(19) **Europäisches Patentamt / European Patent Office / Office européen des brevets**

(11) **EP 2 551 925 B1**

(12) **EUROPEAN PATENT SPECIFICATION**

(45) Date of publication and mention
of the grant of the patent:
**22.08.2018 Bulletin 2018/34**

(21) Application number: **11759434.1**

(22) Date of filing: **23.03.2011**

(51) Int Cl.:
*H01L 33/42* (2010.01)     *H01L 33/32* (2010.01)
*H01L 33/00* (2010.01)

(86) International application number:
**PCT/JP2011/056976**

(87) International publication number:
**WO 2011/118629 (29.09.2011 Gazette 2011/39)**

(54) **Method of manufacturing a nitride semiconductor light emitting element**

Herstellungsverfahren eines LICHTEMITTIERENDEn NITRID-HALBLEITERELEMENTS

Procédé de fabrication d'un ÉLÉMENT LUMINESCENT SEMI-CONDUCTEUR DE NITRURE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.03.2010 JP 2010066737**

(43) Date of publication of application:
**30.01.2013 Bulletin 2013/05**

(73) Proprietor: **Nichia Corporation
Kaminaka-cho
Anan-shi
Tokushima 774-8601 (JP)**

(72) Inventor: **MUSASHI, Naoki
Anan-shi
Tokushima 774-8601 (JP)**

(74) Representative: **Betten & Resch
Patent- und Rechtsanwälte PartGmbB
Maximiliansplatz 14
80333 München (DE)**

(56) References cited:
FR-A1- 2 683 219     JP-A- 11 251 634
JP-A- 2002 260 447     JP-A- 2004 179 365
JP-A- 2004 287 281     JP-A- 2007 305 975
JP-A- 2007 305 975     US-A1- 2004 113 156

- **TOSHIRO MARUYAMA ET AL: "GERMANIUM-AND SILICON-DOPED INDIUM-OXIDE THIN FILMS PREPARED BY RADIO-FREQUENCY MAGNETRON SPUTTERING", APPLIED PHYSICS LETTERS, AMERICAN INSTITUTE OF PHYSICS, 2 HUNTINGTON QUADRANGLE, MELVILLE, NY 11747, vol. 64, no. 11, 14 March 1994 (1994-03-14), pages 1395-1397, XP000434305, ISSN: 0003-6951, DOI: 10.1063/1.111894**

**Description**

BACKGROUND OF THE INVENTION

Field of the Invention

The present invention relates to a method of manufacturing a nitride semiconductor light emitting element having a transparent conductive oxide film as an electrode.

Description of the Related Art

Conventionally, a nitride semiconductor light emitting element structure in which a p-type semiconductor layer and an n-type semiconductor layer are stacked on a substrate and electrodes electrically connected to the p-type and n-type semiconductor layers respectively are formed is known. Furthermore, a structure of the electrode electrically connected to the p-type semiconductor in which an electrode made of a transparent material is formed on a whole surface of the p-type semiconductor layer and a metal electrode is formed thereon is known.

In the nitride semiconductor light emitting element having such a configuration, ITO (indium oxide containing 3 to 5% by weight of $SnO_2$) is widely used as the whole surface electrode in order to improve an efficiency of extracting light(see, for example, Patent Literatures 1-2).

However, ITO is not always in good ohmic contact with a semiconductor layer since ITO exhibits an n-type semiconductor property. By various factors such as a type and a conductive type of the semiconductor layer, and a method of film forming, a Schottky barrier may be formed. As a result a contact resistance may increase. Furthermore, when ITO is used as the electrode, there is variability of a forward voltage (Vf) among the light emitting elements made from the same wafer. Accordingly, a transparent electrode which can reduce the variability of the forward voltage among the light emitting elements is required.

Citation List

Patent Literature

Patent Literature 1: JP 2001-210867 A
Patent Literature 2: JP 2003-60236 A
Patent Literature 3: JP2007-305975 A

SUMMARY OF THE INVENTION

The present invention is made in consideration of above-mentioned problems, and an object of the present invention is to manufacture a nitride semiconductor light emitting element having a novel transparent electrode and a method of manufacturing the same. The nitride semiconductor light emitting element has the transparent electrode on a p-type nitride semiconductor layer, wherein the p-type nitride semiconductor layer and the transparent electrode can be in good ohmic contact with each other and wherein the variability of the forward voltage (Vf) among a plurality of light emitting elements made from the same wafer can be reduced.

The present invention is a method of manufacturing a nitride semiconductor light emitting element including: an n-side nitride semiconductor layer; a p-side nitride semiconductor layer; and a transparent electrode formed on the p-side nitride semiconductor layer, wherein the transparent electrode is made of indium oxide containing Ge and Si.

Preferably, the nitride semiconductor light emitting element includes one or more features as follows:

(1) the transparent electrode is in contact with a p-type nitride semiconductor layer included in the p-side nitride semiconductor layer

(2) the transparent electrode contains indium oxide as a major component, 0.1% or more by weight and 5.0% or less by weight of germanium oxide, and 0.1% or more by weight and 5.0% or less by weight of silicon oxide.

(3) the p-type nitride semiconductor layer included in the p-side nitride semiconductor layer is made of GaN.

(4) the p-type nitride semiconductor layer included in the p-side nitride semiconductor layer contains Mg as a p-type impurity.

(5) a thickness of the transparent electrode is in a range from 500 Å to 5000 Å.

The present invention is a method of manufacturing a nitride semiconductor light emitting element including an n-side nitride semiconductor layer, a p-side nitride semiconductor layer, and a transparent electrode formed on the p-side nitride semiconductor layer, the method including: a semiconductor forming step of forming the n-side nitride semiconductor layer and the p-side nitride semiconductor layer; and a transparent electrode forming step of forming the transparent electrode on the p-side nitride semiconductor layer, wherein the transparent electrode forming step comprises a film forming sub-step of forming an indium oxide layer containing Ge and Si, and a annealing sub-step of annealing the nitride semiconductor light emitting element having the indium oxide layer.

According to the method of manufacturing a nitride semiconductor element it is possible to provide the nitride semiconductor light emitting element which has a low forward voltage Vf and has less variability of the forward voltage (among a plurality of light emitting elements made from the same wafer).

BRIEF DESCRIPTION OF THE DRAWINGS

Fig. 1 is a schematic top view of a nitride semiconductor light emitting element of one embodiment of the present invention.
Fig. 2 is a schematic cross-sectional view taken along a line A-A' in Fig. 1.

DETAILED DESCRIPTION OF THE INVENTION

Hereinafter, a method of manufacturing a nitride semiconductor light emitting element of the present invention will be described with reference to the drawings.

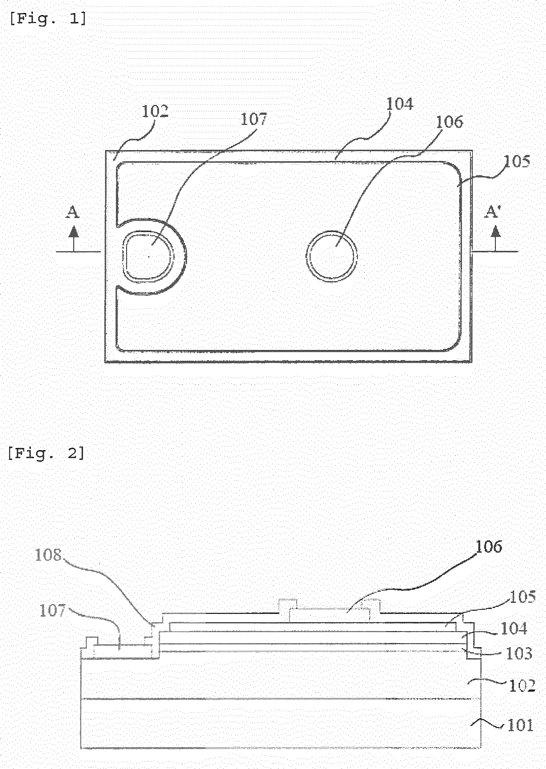

Fig. 1 is a schematic top view of a nitride semiconductor light emitting element of one embodiment of the present invention, and Fig. 2 is a schematic cross-sectional view taken along a line A-A' in Fig. 1.

The nitride semiconductor light emitting element shown in Figs. 1 and 2 has a layer configuration in which an n-side nitride semiconductor layer 102, a light emitting layer 103, and a p-side nitride semiconductor layer 104 are stacked on a substrate 101 in this order. A transparent electrode 105 and a p-side pad electrode 106 formed on a part of a surface of the transparent electrode 105 are provided on a surface of the p-side nitride semiconductor layer 104, and an n-side electrode 107 is provided on a partially notched surface in the n-side nitride semiconductor layer 102. An insulating layer 108 with openings corresponding to parts of the p-side pad electrode and the n-side pad electrode is provided.

The term "the n-side nitride semiconductor layer 102" as used herein implies a nitride semiconductor layer functioning as an n-type semiconductor layer of a light emitting element. If the n-side nitride semiconductor layer 102 can function as the n-type semiconductor layer, the n-side nitride semiconductor layer 102 can be configured with a multilayer structure including a layer other than an n-type nitride semiconductor layer (such as a p-type nitride semiconductor layer).

Similarly, the term "the p-side nitride semiconductor layer 104" implies a nitride semiconductor layer functioning as a p-type semiconductor layer of the light emitting element. If the p-side nitride semiconductor layer 104 can function as the p-type semiconductor layer, the p-side nitride semiconductor layer 104 can be configured with a multilayer structure including a layer other than a p-type nitride semiconductor layer (such as an n-type nitride semiconductor layer).

In the present invention, by using indium oxide containing Ge and Si as a material of the transparent electrode 105, the light emitting element having a low contact resistance with the p-type nitride semiconductor layer, a low forward voltage Vf, and a high light output can be provided. Though the reason why these effects can be obtained is not known so far, it is considered that the reason is because Ge has a greater binding energy to hydrogen as compared with that of Sn contained in ITO as a conventional transparent electrode material.

A conductive type of a nitride semiconductor is usually an n-type. Therefore, the nitride semiconductor is doped with a p-type dopant and applied energy such as by annealing to obtain a p-type nitride semiconductor. It is considered that this p-type nitride semiconductor contains hydrogen which causes increased electrical resistance of the p-type nitride semiconductor and increased contact resistance between the p-type nitride semiconductor and the transparent electrode.

According to the present invention, it is considered that Ge stores hydrogen since the transparent electrode 105 formed on the p-side nitride semiconductor layer 104 contains Ge (which has the larger binding energy to hydrogen as compared with Sn). As a result, it is considered that, hydrogen amount on or near a surface of the p-type nitride semiconductor layer composing the p-side nitride semiconductor layer 104 is decreased, thereby decreasing a contact resistance between the p-type nitride semiconductor layer and the transparent electrode. In addition, it is considered that the electrical resistance of the p-type nitride semiconductor layer also decrease since Ga contained in the transparent electrode 105 also stores hydrogen contained in an inside of the p-type nitride semiconductor layer.

Taking account of a mechanism of the hydrogen storage by Ga, in order to increase an effect of storing hydrogen from the surface of the p-type nitride semiconductor layer, it is preferred that the transparent electrode 105 is in contact with the surface of the p-type nitride semiconductor layer. When the p-side nitride semiconductor layer 104 is composed of the multilayer structure, a top layer of the multilayer structure is preferably the p-type nitride semiconductor layer.

However, even if there is another layer (such as a non-doped nitride semiconductor layer or an n-type nitride semiconductor layer) between the p-type nitride semiconductor layer and the transparent electrode 105, namely, even if the top layer of the multilayer structure of the p-side nitride semiconductor layer 104 is the other layer, the object of the present invention can be achieved as long as Ge can store hydrogen from the p-type nitride semiconductor layer via the other layer (for example, when the other layer is thin). Accordingly, it should be understood that the nitride semiconductor light emitting element of the present invention includes a nitride semiconductor light emitting element having another layer between the p-type nitride semiconductor layer and the transparent electrode 105.

According to the nitride semiconductor light emitting element of the present invention, the transparent electrode 105 is made of indium oxide containing Ge and Si. Particularly, the transparent electrode 105 is preferably made of indium oxide which contains indium oxide as a major component, 0.1% or more by weight and 5.0% or less by weight of germanium oxide, and 0.1% or more by weight and 5.0% or less by weight of silicon oxide.

In addition, the p-side nitride semiconductor layer 104 is preferably made of $In_\alpha Al_\beta Ga_{1-\alpha-\beta}N$ ($0 \leq \alpha$, $0 \leq \beta$, $\alpha+\beta \leq 1$). When the p-side nitride semiconductor layer 104 is composed of the multilayer structure, the top layer of the p-side nitride semiconductor layer 104 is preferably made of $In_\alpha Al_\beta Ga_{1-\alpha-\beta}N$ ($0 \leq \alpha$, $0 \leq \beta$, $\alpha+\beta \leq 1$).

Particularly, the p-side nitride semiconductor layer 104 (the top layer of the p-side nitride semiconductor layer 104 if composed of the multilayer structure) is more preferably made of GaN (i.e. $\alpha=0$ and $\beta=0$), thereby forming the p-side nitride semiconductor layer with good crystallinity, which makes it possible to achieve good ohmic contact between the p-side nitride semiconductor layer 104 and the transparent electrode 105.

As a P-type dopant contained in the p-side nitride semiconductor layer 104, p-type impurities such as Be, Zn, Mn, Cr, Mg and Ca can be used. Among this, using Mg is preferred. A concentration of the p-type impurities contained in the p-type nitride semiconductor layer is preferably $1 \times 10^{18}/cm^3$ or more and $5 \times 10^{21}/cm^3$ or less.

Preferably, the thickness of the transparent electrode 105 is 500 Å or more and 5000 Å or less. If the thickness is less than 500 Å, a sheet resistance of the transparent electrode 105 is too high to spread current enough. If the thickness is more than 5000 Å, translucency of the transparent electrode 105 is too low, and decreases the efficiency of extracting light.

In order to be able to form a semiconductor composing the n-side nitride semiconductor layer 102 on the substrate 101 by epitaxial growth, the substrate 101 is made of a material having lattice coherency with the semiconductor. An area and a thickness of the substrate 101 are not limited in particular. The material for the substrate 101 includes, for example, insulating materials such as sapphire and spinal; silicon carbide; $SiO_2$; ZnS; ZnO; Si; GaAs; diamond; and oxide materials such as lithium niobate and Neodymium Gallate.

The n-side nitride semiconductor layer 102 formed on the substrate 101 is made by doping a semiconductor material layer with an n-type dopant. The p-side nitride semiconductor layer 104 formed on the n-side nitride semiconductor layer 102 via the light emitting layer 103 is made by doping a semiconductor material layer with a p-type dopant to form the p-type semiconductor. Specific examples of the semiconductor material for forming the n-side and the p-side nitride semiconductor layers 102, 104 is a III-V group nitride semiconductor of $In_\alpha Al_\beta Ga_{1-\alpha-\beta}N$ ($0 \leq \alpha$, $0 \leq \beta$, $\alpha+\beta \leq 1$), or a mixed crystal in which a part of the III-V group nitride semiconductor is substituted with other elements (for example, the mixed crystal in which a part of or all III group elements is substituted with B and/or a part of V group element (N) is substituted with P, As, Sb and the like). The n-type dopant (n-type impurity) doped to the semiconductor is, for example, IV or VI group element such as Si, Ge, Sn, S, O, Ti, Zr and the like. The p-type dopant (p-type impurity) is, for example, Be, Zn, Mn, Cr, Mg, Ca and the like.

The n-side nitride semiconductor layer 102 and the p-side nitride semiconductor layer 104 may be composed of the multilayer structures. If composed of the multilayer structures, a part of the n-side nitride semiconductor layer 102 may include a p-type nitride semiconductor layer as long as the n-side nitride semiconductor layer 102 functions as n-type in the light emitting element, and a part of the p-side nitride semiconductor layer 104 may include an n-type nitride semiconductor layer as long as the p-side nitride semiconductor layer 104 functions as p-type in the light emitting element.

A buffer layer may be formed between the substrate 101 and the n-side nitride semiconductor layer 102.

The light emitting layer 103 is an n-type or p-type nitride semiconductor layer. Into the light emitting layer 103, electrons are injected from the n-side nitride semiconductor layer 102 and holes are injected from the p-side nitride semiconductor layer 104. The Energy generated by recombining the electrons and the holes is emitted as light. It is preferable that the light emitting layer 103 has a quantum well structure including well layers and barrier layers. If the light emitting element can emit light by direct contact between the n-side nitride semiconductor layer 102 and the p-side nitride semiconductor layer 104, the light emitting layer 103 may be omitted.

Hereinafter, a method of manufacturing the nitride semiconductor light emitting element of the present invention will be described.

The method of manufacturing the nitride semiconductor light emitting element includes a semiconductor forming step of forming the n-side nitride semiconductor layer and the p-side nitride semiconductor layer and a transparent electrode forming step of forming the transparent electrode on the p-side nitride semiconductor layer.

The transparent electrode forming step includes a film forming sub-step of forming an indium oxide layer containing Ge and Si, and an annealing sub-step of annealing the nitride semiconductor light emitting element having the indium oxide layer.

The annealing sub-step (heat treatment step) is carried out after the film forming sub-step in which the transparent electrode 105 is formed on the p-side nitride semiconductor layer 104. By the annealing sub-step, good ohmic contact between the p-side nitride semiconductor layer 104 and the transparent electrode 105 is achieved.

In the film forming sub-step in which the transparent electrode 105 made of indium oxide containing Ge and Si is formed on the p-side nitride semiconductor layer 104, commonly known film forming techniques such as physical vapor deposition and chemical vapor deposition (for example, sputtering method, vapor deposition method, laser ablation method, spin coating method, spray coating method, dip coating method and the like) can be used. Particularly, the sputtering method using a target comprising indium oxide containing Ge and Si is preferable.

Regarding an atmosphere in a sputtering device, for the conventional ITO transparent electrode, ITO was formed while introducing oxygen gas into the sputtering device (i.e. under an oxygen containing atmosphere). ITO formed by the sputtering method has oxygen content significantly lower than a theoretical value since deoxygenation takes place during sputtering. By sputtering under the oxygen containing atmosphere, the oxygen content of the formed ITO becomes close to the theoretical value. ITO transparent electrode formed in this way is regarded as being in good ohmic contact with the nitride semiconductor layer.

However, it is found that, the transparent electrode 105 made of indium oxide containing Ge and Si is formed by sputtering under the oxygen containing atmosphere, it is difficult to achieve ohmic contact with the p-side nitride semiconductor layer 104. Accordingly, in the present invention, it is preferable that the transparent electrode 105 made of indium oxide containing Ge and Si is formed under an atmosphere not containing oxygen (under an inert gas atmosphere). The transparent electrode 105 formed under the inert gas atmosphere is in good ohmic contact with the p-side nitride semiconductor layer 104.

It should be understood that the term "the inert gas atmosphere" indicates not only the inert gas atmosphere containing no oxygen but also the inert gas atmosphere containing low content of oxygen (specifically, 0.2 % or less by volume relative to the inert gas) so as not to substantially be affected by oxygen content.

Regarding an annealing temperature and an annealing pressure in the annealing sub-step, the conventional ITO transparent electrode was annealed at the annealing temperature of 300 to 475°C under the annealing pressure of an atmospheric pressure. By annealing at this temperature under this pressure, ITO transparent electrode is regarded as decreasing the sheet resistance and becoming in good ohmic contact with the p-side nitride semiconductor layer.

However, if the transparent electrode 105 made of indium oxide containing Ge and Si is annealed at the annealing temperature of 300 to 475°C under the atmospheric pressure, the sheet resistance of the transparent electrode 105 somewhat decreases but the ohmic contact with the p-side nitride semiconductor layer 104 can not be achieved. If the annealing temperature increases to 500°C or more, the ohmic contact can be achieved but the sheet resistance of the transparent electrode 105 increases. Generally, it has been believed that the annealing temperature of 500°C or more is inappropriate since an increased sheet resistance causes increasing the Vf. Unexpectedly, however, according to actual measurement of Vf of the nitride semiconductor light emitting element of the present invention annealed at the temperature of 500°C or more, it is found that the forward voltage (Vf) decreases. Although the exact theory why Vf decreases is unclear so far, it is considered that the effect of storing hydrogen from p-type nitride semiconductor layer by Ge contained in the transparent electrode 105 is effectively exerted when the annealing temperature is 500°C or more.

These results indicate that 500°C or more of the annealing temperature of the nitride semiconductor light emitting element using the transparent electrode 105 made of indium oxide containing Ge and Si is preferable in light of the ohmic contact and the decrease in Vf. That is, according to the nitride semiconductor light emitting element of the present invention, the effect of good ohmic contact between the transparent electrode 105 and the p-side nitride semiconductor layer 104 and the effect of decrease in Vf of the transparent electrode 105 are obtained when annealed at 500°C or more (although the sheet resistance of the transparent electrode 105 increases).

Furthermore, when paying attention to the contact resistance, the anneal temperature is preferably 525°C or more. The contact resistance between the transparent electrode 105 and the nitride semiconductor light emitting element may decrease when the anneal temperature is 525°C or more.

It is not possible to directly measure a temperature of the nitride semiconductor light emitting element during the annealing sub-step. For this reason, temperature control during the annealing sub-step is based on a measured value of a heater temperature in an annealing treatment device. The heater temperature in the annealing treatment device is considered as "the annealing temperature" as used herein.

Regarding the anneal pressure, when annealing under the atmospheric pressure (0.1 MPa) as the same for the conventional ITO transparent electrode, the transparent electrode 105 made of indium oxide containing Ge and Si has higher sheet resistance. On the other hand, it was found that, when annealing under high vacuum ($10^{-4}$ to 1 Pa), the sheet resistance of the transparent electrode 105 decreases but there was a possibility that the ohmic contact between the transparent electrode 105 and the p-side nitride semiconductor layer 104 was not achieved. However, it was also found that, when annealing under reduced pressure of 1 kPa to 30 kPa, the transparent electrode 105 and the p-side nitride semiconductor layer 104 are in ohmic contact with each other and the sheet resistance and the forward voltage Vf decrease (compared with the case of the atmospheric pressure annealing).

These results indicate that the nitride semiconductor light emitting element using the transparent electrode 105 made of indium oxide containing Ge and Si is preferably annealed under the reduced pressure in light of the ohmic contact and the sheet resistance. That is, when the nitride semiconductor light emitting element of the present invention is annealed under the reduced pressure, the effect of good ohmic contact between the transparent electrode 105 and the p-side nitride semiconductor layer 104 and the effect of decrease in the sheet resistance of the transparent electrode 105 are obtained.

The term "the reduced pressure" in the present invention means a pressure in the range of 1 kPa to 30 kPa.

In the nitride semiconductor light emitting element of the present invention, in order to investigate the effects obtained by the use of the transparent electrode 105 made of indium oxide containing Ge and Si, the light emitting element was evaluated in following ways.

(1) Evaluation of Variability of Vf

The variability of the forward voltage (Vf) is evaluated among a plurality of nitride semiconductor light emitting elements manufactured at the same time.

A plurality of nitride semiconductor light emitting elements (sample elements S) which has the transparent electrode 105 made of indium oxide containing Ge and Si and formed on the p-side nitride semiconductor layer 104 is manufactured in the same wafer. The n pieces of the sample elements S are sampled and Vf thereof are measured. For comparison, a plurality of comparative elements $S_{ITO}$ having the ITO transparent electrode formed on the p-side nitride semiconductor layer is manufactured in the same wafer. The n pieces of the comparative elements $S_{ITO}$ are sampled and $Vf_{ITO}$ thereof are measured.

The variability of Vf is evaluated on the basis of a value of $3\sigma$ which is three times a standard deviation ($\sigma$). The smaller the value of $3\sigma$, the smaller the variability of Vf.

The standard deviation ($\sigma$) is calculated according to the following steps (a)-(c):

(a) The measured values of Vf of the n pieces of the sampled light emitting elements are referred to as $t_1, t_2, ..., t_n$. An average value of the measured values of Vf ($t_1, t_2, ..., t_n$) is referred to as $t_a$.
(b) Subtracting $t_a$ from each measured value ($t_1, t_2, ..., t_n$) of Vf and squaring the results. Adding all of obtained values and dividing the result by n.
(c) Positive squire root of the result obtained by division is the standard deviation ($\sigma$).

These steps (a)-(c) can be expressed by following formula [1].

$$\sigma = \sqrt{[\{(t_1-t_a)^2 + (t_2-t_a)^2 + ... + (t_n-t_a)^2\}/n]} \qquad \text{Formula[1]}$$

(2) Evaluation of Vf

The nitride semiconductor light emitting element (the sample element S) which has the transparent electrode 105 made of indium oxide containing Ge and Si and formed on the p-side nitride semiconductor layer 104 is manufactured. The forward voltage $Vf_S$ of the sample S is measured. For comparison, the comparative element $S_{ITO}$ having the ITO transparent electrode formed on the p-side nitride semiconductor layer is manufactured, and the forward voltage $Vf_{ITO}$ thereof is measured.

When $Vf_S \leq Vf_{ITO}$, it is evaluated that Vf of the sample element S is good.

(3) Evaluation of Ohmic Contact

The nitride semiconductor light emitting element (the sample element S) which has the transparent electrode 105 made of indium oxide containing Ge and Si and formed on the p-side nitride semiconductor layer 104 is manufactured. A current is measured during applying voltage in the range of -5V to +5V to the sample S, and a V-I curve is plotted. When the V-I curve is linear, it is evaluated that the transparent electrode 105 and the p-side nitride semiconductor layer 104 are in ohmic contact with each other.

(4) Evaluation of Contact Resistance

The nitride semiconductor light emitting element (Sample element S) which has the transparent electrode 105 made of indium oxide containing Ge and Si and formed on the p-side nitride semiconductor layer 104 is manufactured. The contact resistance $\rho c_S$ of the sample S is measured. For comparison, the comparative element $S_{ITO}$ having the ITO transparent electrode formed on the p-side nitride semiconductor layer is manufactured, and the contact resistance $\rho c_{ITO}$ thereof is measured.

When $\rho c_S \leq \rho c_{ITO}$, it is evaluated that the contact resistance of the sample element S is good.

(5) Evaluation of Sheet Resistance

The transparent electrode made of indium oxide containing Ge and Si is formed on a dummy substrate (a glass substrate). The sheet resistance $R_S$ of the transparent electrode is measured. For comparison, the ITO transparent electrode is formed on the dummy substrate (the glass substrate), and the sheet resistance $R_{ITO}$ thereof is measured.

When $R_S \leq R_{ITO}$, it is evaluated that the sheet resistance of the transparent electrode made of indium oxide containing Ge and Si is good.

EXAMPLES

Example 1

For purpose of evaluation of the variability of Vf, a plurality of nitride semiconductor light emitting elements was manufactured at the same time.

The n-side nitride semiconductor layer 102, the light emitting layer 103 and the p-side nitride semiconductor layer 104 were stacked on a sapphire substrate 101 with 2 inch diameter via a AlGaN buffer layer.

The n-side nitride semiconductor layer 102 was formed by stacking undoped GaN (1.5 $\mu m$), Si doped GaN (4.2 $\mu m$), undoped GaN(0.15 $\mu m$), Si doped GaN (0.01 $\mu m$), undoped Gan (0.15 $\mu m$), Si doped GaN (0.03 $\mu m$), undoped GaN (5 nm), and a super lattice layer (120 nm) in which GaN and InGaN were twenty times repeatedly stacked and finally GaN was stacked in this order.

The light emitting layer 103 was formed by repeatedly stacking six times GaN (8 nm) and InGaN (3 nm) and finally stacking GaN (8 nm). The first stacked GaN layer was doped with Si, and the finally stacked GaN layer was not doped.

The p-side nitride semiconductor layer 104 was formed by stacking a super lattice (24 nm) in which Mg doped AlGaN and Mg doped InGaN were three times repeatedly stacked and finally Mg doped AlGaN was stacked, undoped GaN (0.11 $\mu m$), and Mg doped GaN (0.11 $\mu m$) in this order.

The light emitting layer 103 and the p-side nitride semiconductor layer 104 stacked on a partial region of the n-side nitride semiconductor layer 102 were removed, and a part in thickness direction of the n-side nitride semiconductor layer 102 itself was removed to expose the n-side nitride semiconductor layer 102. On the exposed n-side nitride semiconductor layer, the n-side pad electrode 107 was formed. The n-side pad electrode 107 was formed from a stacked structure in which Ti/Rh/W/Au having thicknesses of 2 nm/100 nm/50 nm/550 nm were stacked in this order.

The transparent electrode 105 was formed on a whole surface of the p-side nitride semiconductor layer 104, and the p-side pad electrode 106 was formed on a part of a surface of the transparent electrode 105. The p-side pad electrode 106 was formed from a stacked structure same as that of the n-side pad electrode 107. The insulating layer 108 was formed on a surface of the nitride semiconductor light emitting element excluding parts of the p-side pad electrode 106 and the n-side pad electrode 107.

The transparent electrode 105 having the thickness of 170 nm was formed by the sputtering method using a target comprising indium oxide containing Ge and Si.

After forming the transparent electrode 105, the nitride semiconductor light emitting element was annealed. Annealing conditions were an anneal temperature of 525°C, an annealing atmosphere of $N_2$ and an anneal pressure of 3 kPa.

To evaluate the variability of Vf, 130 pieces of the light emitting elements (the sample elements S) were sampled randomly from a plurality of the nitride semiconductor light emitting elements before dividing (in a state of a wafer) . The forward voltages (Vf) of the 130 pieces of the nitride semiconductor light emitting elements were measured. The standard deviation ($\sigma$) of Vf was calculated by using the formula [1]. $\sigma$ was trebled to obtain $3\sigma$.

This operation was (corresponding to three wafers) carried out three times.

The values of $3\sigma$ of the sample elements S obtained from each of three wafers were 0.100, 0.100 and 0.062.

In addition, the properties were evaluated on the basis of average values of the individual light emitting element obtained by dividing from the wafer and it was found that Vf was 3.18 V and a light output was 24.0 mW when applying current of 20 mA.

For comparison, the light emitting elements (the comparative elements $S_{ITO}$) which were identical with the sample elements S except replacing the transparent electrode with ITO were manufactured. The ITO transparent electrode having a thickness of 170 nm was formed by the sputtering method using an ITO target.

To evaluate the variability of Vf of the comparative elements $S_{ITO}$, 130 pieces of the light emitting elements were sampled randomly from a plurality of the nitride semiconductor light emitting elements before dividing (in a state of the wafer), and the forward voltages (Vf) were measured. The standard deviation $\sigma$ of the Vf was calculated by using the formula [1]. $\sigma$ was trebled to obtain the variability ($3\sigma$). The values of $3\sigma$ obtained from three wafers were 0.280, 0.337 and 0.156.

By comparing the $3\sigma$ values of the sample elements S (0.100, 0.100 and 0.062) with the $3\sigma$ values of the comparative elements $S_{ITO}$ (0.280, 0.337 and 0.156), it was found that the nitride semiconductor light emitting element of the present invention had significantly low variation of Vf compared with that of the nitride semiconductor light emitting element having the conventional ITO transparent electrode.

In addition, the properties were evaluated on the basis of average values of the individual light emitting element obtained by dividing the wafer and it was found that Vf was 3.24 V and a light output was 21.9 mW when applying current of 20 mA. That is, Vf of the nitride semiconductor light emitting device of the present invention is lowered by 0.05 V in comparison with that of the nitride semiconductor light emitting device having the conventional ITO transparent electrode. Furthermore, the light output is improved about 10%.

Example 2

An effect of annealing conditions of the transparent electrode 105 on the forward voltage Vf was evaluated.

This example was different from Example 1 in that measurement was carried out after dividing the wafer into chips. Other than that was the same as Example 1.

As the same for Example 1, the n-side nitride semiconductor layer 102, the light emitting layer 103 and the p-side nitride semiconductor layer 104 were stacked, and the transparent electrode 105 was formed.

The transparent electrode 105 having the thickness of 170 nm was formed under Ar atmosphere by the sputtering method using the target comprising indium oxide containing Ge and Si.

After forming the transparent electrode 105, the nitride semiconductor light emitting element was annealed. The annealing conditions (the annealing temperature, the annealing atmosphere and the annealing pressure) were listed in Tables 1 and 2.

As the same for Example 1, the n-side pad electrode 107, the p-side pad electrode 106 and the insulating layer 108 were formed after annealing. Division into individual light emitting element was carried out to obtain the sample elements S.

The forward voltages $Vf_S$ of the nitride semiconductor light emitting elements (the sample elements S) having the transparent electrode made of indium oxide containing Ge and Si were measured. For comparison, the light emitting element (the comparative element $S_{ITO}$) having the ITO transparent electrode was manufactured, and the forward voltage $Vf_{ITO}$ thereof was measured. Measurement results were listed in Tables 1 and 2.

When $Vf_S \leq Vf_{ITO}$, it was evaluated that Vf of the sample element S was good.

Comparison of Vf between the sample element S and the comparative element $S_{ITO}$, of which the film formings were carried out with the same sputtering device was made. For six sample elements S (Nos. 1-6) and one $S_{ITO}$ (No. 7) in Table 1, the same sputtering device was used. For four sample elements S (Nos. 8-11) and one $S_{ITO}$ (No. 12) in Table 1, the same sputtering device was used.

Table 1

| No . | film composition | film forming condition | | annealing condition | | | Vf (V) |
|------|------------------|------------|------------|-------------------|------------|---------------|--------|
|      |                  | under layer | atmosphere | temperature (°C) | atmosphere | pressure (Pa) |        |
| 1 | IGS | p-GaN | Ar | 450 | air | 3k | 8.10 |
| 2 | IGS | p-GaN | Ar | 475 | air | 3k | 3.29 |
| 3 | IGS | p-GaN | Ar | 500 | air | 3k | 3.05 |
| 4 | IGS | p-GaN | Ar | 525 | air | 3k | 3.04 |

(continued)

| No. | film composition | film forming condition | | annealing condition | | | Vf (V) |
|---|---|---|---|---|---|---|---|
| | | under layer | atmosphere | temperature (°C) | atmosphere | pressure (Pa) | |
| 5 | IGS | p-GaN | Ar | 550 | air | 3k | 3.04 |
| 6 | IGS | p-GaN | Ar | 575 | air | 3k | 3.05 |
| 7 | ITO | p-GaN | Ar+$O_2$ | 475 | air | atmospheric pressure | 3.08 (comparative) |
| *IGS: the transparent electrode 105 was formed from an indium oxide film containing Ge and Si<br>ITO: the transparent electrode was formed from an ITO film (comparative sample)<br>p-GaN: the p-side nitride semiconductor layer | | | | | | | |

Table 2

| No. | film composition | film forming condition | | annealing condition | | | Vf (V) |
|---|---|---|---|---|---|---|---|
| | | under layer | atmosphere | temperature (°C) | atmosphere | pressure (Pa) | |
| 8 | IGS | p-GaN | Ar | 525 | air | 1k | 2.99 |
| 9 | IGS | p-GaN | Ar | 525 | air | 3k | 3.00 |
| 10 | IGS | p-GaN | Ar | 525 | air | 60k | 3.03 |
| 11 | IGS | p-GaN | Ar | 525 | air | atmospheric pressure | 3.02 |
| 12 | ITO | p-GaN | Ar | 475 | air | atmospheric pressure | 2.99 (comparative) |
| *IGS: the transparent electrode 105 was formed from an indium oxide film containing Ge and Si<br>ITO: the transparent electrode was formed from an ITO film (comparative sample)<br>p-GaN: the p-side nitride semiconductor layer | | | | | | | |

Example 3

An effect of film forming conditions and the annealing conditions of the transparent electrode 105 on the ohmic contact was evaluated.

This example was different from Example 1 in the film forming conditions of the transparent electrode 105. Furthermore, this example was different from Example 1 in that measurement was carried out after dividing the wafer into chips. Other than that was the same as Example 1.

As the same for Example 1, the n-side nitride semiconductor layer 102, the light emitting layer 103 and the p-side nitride semiconductor layer 104 were stacked, and the transparent electrode 105 was formed.

The transparent electrode 105 having the thickness of 170 nm was formed by the sputtering method using the target comprising indium oxide containing Ge and Si. The samples were formed under different atmospheres in the sputtering device during film forming. The atmosphere for each sample was, Ar only (sample Nos. 13 and 16-19); Ar and $O_2$ (Ar flow rate: 60 sccm (Standard Cubic Centimeters per Minute), $O_2$ flow rate: 0.27 sccm) (sample No. 14); and Ar and $O_2$ (Ar flow rate: 60 sccm, $O_2$ flow rate: 0.6 sccm) (sample No. 15).

After forming the transparent electrode 105, the nitride semiconductor light emitting element was annealed. The annealing conditions (the annealing temperature, the annealing atmosphere and the annealing pressure) were listed in Table 3.

As the same for Example 1, the n-side pad electrode 107, the p-side pad electrode 106 and the insulating layer 108 were formed after annealing. Division into individual light emitting element was carried out to obtain six sample elements S.

Currents were measured during applying voltage in the range of -5V to +5V to six samples S, and the V-I curves were plotted. When the V-I curve was linear, the ohmic contact was evaluated as good (O). When the V-I curve was curved (for example, curved in s shape), the ohmic contact was evaluated as not good (X). Evaluation results were listed in Table 3.

Table 3

| No. | film composition | film forming condition | | annealing condition | | | ohmic contact |
|---|---|---|---|---|---|---|---|
| | | under layer | atmosphere | temperature (°C) | atmosphere | pressure (Pa) | |
| 13 | IGS | p-GaN | Ar | 525 | $N_2$ | 3k | ○ |
| 14 | IGS | p-GaN | Ar(60 sccm)+ $O_2$(0.27 sccm) | 525 | $N_2$ | 3k | X |
| 15 | IGS | p-GaN | Ar(60 sccm)+ $O_2$(0.6 sccm) | 525 | $N_2$ | 3k | X |
| 16 | IGS | p-GaN | Ar | 475 | $N_2$ | atmospheric pressure | X |
| 17 | IGS | p-GaN | Ar | 500 | $N_2$ | atmospheric pressure | ○ |
| 18 | IGS | p-GaN | Ar | 525 | $N_2$ | atmospheric pressure | ○ |
| 19 | IGS | p-GaN | Ar | 500 | - | 0.001 | X |
| *IGS: the transparent electrode 105 was formed from an indium oxide film containing Ge and Si p-GaN: the p-side nitride semiconductor layer 104 | | | | | | | |

Example 4

An effect of the annealing conditions of the transparent electrode 105 on the contact resistance was evaluated.

This example was different from Example 1 in that measurement was carried out after dividing the wafer into chips. Other than that was the same as Example 1.

As the same for Example 1, the n-side nitride semiconductor layer 102, the light emitting layer 103 and the p-side nitride semiconductor layer 104 were stacked, and the transparent electrode 105 was formed.

The transparent electrode 105 having the thickness of 170 nm was formed under Ar atmosphere by the sputtering method using the target comprising indium oxide containing Ge and Si.

After forming the transparent electrode 105, the nitride semiconductor light emitting element was annealed. The annealing conditions (the annealing temperature, the annealing atmosphere and the annealing pressure) were listed in Table 4.

As the same for Example 1, the n-side pad electrode 107, the p-side pad electrode 106 and the insulating layer 108 were formed after annealing. Division into individual light emitting element was carried out to obtain the sample elements S.

The contact resistances $\rho c_S$ of the nitride semiconductor light emitting elements (the sample elements S) having the transparent electrode made of indium oxide containing Ge and Si were measured. For comparison, the light emitting element (the comparative element $S_{ITO}$) having the ITO transparent electrode was manufactured, and the contact resistance $\rho c_{ITO}$ thereof was measured. Measurement results were listed in Table 4.

When $\rho c_S \leq \rho c_{ITO}$, it was evaluated that the contact resistance of the sample element S was good.

Table 4

| No. | film composition | film forming condition | | annealing condition | | | $\rho c$ |
|---|---|---|---|---|---|---|---|
| | | under layer | atmosphere | temperature (°C) | atmosphere | pressure (Pa) | |
| 20 | IGS | p-GaN | Ar | 500 | $N_2$ | 3k | 20.45 |
| 21 | IGS | p-GaN | Ar | 525 | $N_2$ | 3k | 3.538 |
| 22 | IGS | p-GaN | Ar | 550 | $N_2$ | 3k | 3.672 |

(continued)

| No. | film composition | film forming condition | | annealing condition | | | $\rho c$ |
|---|---|---|---|---|---|---|---|
| | | under layer | atmosphere | temperature (°C) | atmosphere | pressure (Pa) | |
| 23 | ITO | p-GaN | Ar+O$_2$ | 475 | air | atmospheric pressure | 5.781 (comparative) |
| *IGS: the transparent electrode 105 was formed from an indium oxide film containing Ge and Si ITO: the transparent electrode was formed from an ITO film (comparative sample) p-GaN: the p-side nitride semiconductor layer | | | | | | | |

Example 5

An effect of the annealing conditions of the transparent electrode 105 on the sheet resistance was evaluated.

In this example, the transparent electrode 105 made of indium oxide containing Ge and Si was formed on a dummy substrate (a glass substrate).

The transparent electrode 105 having the thickness of 170 nm was formed under Ar atmosphere by the sputtering method using the target comprising indium oxide containing Ge and Si.

After forming the transparent electrode 105, the nitride semiconductor light emitting element was annealed. The annealing conditions (the annealing temperature, the annealing atmosphere and the annealing pressure) were listed in Table 5.

The Sheet resistances $R_s$ of the transparent electrodes 105 made of indium oxide containing Ge and Si formed on the dummy substrate (the glass substrate) were measured. For comparison, the ITO transparent electrode was formed on the dummy substrate (the glass substrate), and the sheet resistance $R_{ITO}$ thereof was measured. Measurement results were listed in Table 5.

When $R_S \leq R_{ITO}$, it was evaluated that the sheet resistance of the transparent electrode made of indium oxide containing Ge and Si was good.

Table 5

| No. | film composition | film forming condition | | annealing condition | | | R(Ω/□) |
|---|---|---|---|---|---|---|---|
| | | under layer | atmosphere | temperature (°C) | atmosphere | pressure (Pa) | |
| 24 | IGS | glass | Ar | 500 | N$_2$ | atmospheric pressure | 60.24 |
| 25 | IGS | glass | Ar | 550 | N$_2$ | atmospheric pressure | 81.1 |
| 26 | IGS | glass | Ar | 600 | N$_2$ | atmospheric pressure | 103 |
| 27 | IGS | glass | Ar | 500 | - | 0.001 | 17.9 |
| 28 | IGS | glass | Ar | 600 | - | 0.001 | 18.4 |
| 29 | IGS | glass | Ar | 600 | N$_2$ | reduced pressure | 41.5 |
| 30 | ITO | glass | Ar+O$_2$ | 475 | N$_2$ | atmospheric pressure | 30.21 (comparative) |
| *IGS: the transparent electrode 105 was formed from an indium oxide film containing Ge and Si ITO: the transparent electrode was formed from an ITO film (comparative sample) | | | | | | | |

The results of sample Nos. 13-15 in Table 3 indicate that the transparent electrode 105 formed under the oxygen containing atmosphere was not in ohmic contact with the p-side nitride semiconductor layer 104. On the other hand, it was found that the transparent electrode 105 formed under the inert gas atmosphere which was not contain oxygen was in ohmic contact with the p-side nitride semiconductor layer 104.

The results of sample Nos. 24-26 in Table 5 indicate that, in the atmospheric pressure annealing, the sheet resistance increases with increasing the annealing temperature (500°C → 550°C → 600°C). Furthermore, the results of sample Nos. 27 and 28 in Table 5 indicate that, in the vacuum annealing, the sheet resistance increases with increasing the annealing temperature (500°C → 600°C).

The results of sample Nos. 16-18 in Table 3 indicate that, in the atmospheric pressure annealing, the transparent electrode 105 and the p-side nitride semiconductor layer 104 were in ohmic contact with each other when annealing at the annealing temperature of 500°C or more.

The results of sample Nos. 1-6 in Table 1 indicate that, in the reduced pressure annealing (3 kPa), Vf of the nitride semiconductor light emitting element was lower than Vf of the conventional ITO nitride semiconductor light emitting element (sample No. 7) when annealing at the annealing temperature of 500°C or more.

These results indicate that, according to the nitride semiconductor light emitting element of the present invention, when the annealing temperature increases to 500°C or more, although the sheet resistance of the transparent electrode 105 increases, the transparent electrode 105 and the p-side nitride semiconductor layer 104 are in ohmic contact with each other and the forward voltage (Vf) decreases.

The results of sample Nos. 20-22 in Table 4 indicate that, when annealing at the annealing temperature of 525°C or more, the contact resistance $\rho c$ of the nitride semiconductor light emitting element is lower than the contact resistance $\rho c$ of the conventional ITO nitride semiconductor light emitting element (sample No. 23).

The result of sample No. 19 in Table 3 indicates that, when annealing under high vacuum (0.001 Pa), the transparent electrode 105 and the p-side nitride semiconductor layer 104 can not be in ohmic contact with each other.

The results of sample Nos. 13 and 18 in Table 3 indicate that, when annealing temperature is 525°C, the ohmic contact between the transparent electrode 105 and the p-side nitride semiconductor layer 104 can be achieved by the annealing pressure of both the atmospheric pressure and the reduced pressure (3 kPa).

The results of sample Nos. 27 and 28 in Table 5 indicate that, when annealing under high vacuum (0.001 Pa), the sheet resistance R of the transparent electrode 105 made of indium oxide containing Ge and Si is lower than the sheet resistance R of the conventional transparent electrode made of ITO (sample No. 30). It was found that the sheet resistance of the transparent electrode 105 annealed under the reduced pressure (sample No. 29) was lower than that of the transparent electrode 105 annealed under the atmospheric pressure (sample No. 26).

The results of sample Nos. 8-11 in Table 2 indicate that Vf of the sample S annealed under the annealing pressure of 60 kPa (sample No. 10) is higher than Vf of the sample S annealed under the atmospheric pressure (sample No. 11). On the other hand, it was found that Vf of the samples S annealed under the reduced pressure (sample Nos. 8 and 9) were lower than Vf of the sample S annealed under the atmospheric pressure (sample No. 11).

Vf of the sample S annealed under the annealed pressure of 1 kPa (sample No. 8) is equivalent to Vf of the conventional ITO nitride semiconductor light emitting element (sample No. 12). Vf of the sample S annealed under the annealed pressure of 3 kPa (sample No. 9) has Vf value good enough although it is slightly higher than Vf of the conventional ITO nitride semiconductor light emitting element (sample No. 12).

These results indicate that, regarding all of important properties for the semiconductor light emitting element (the ohmic contact, the sheet resistance of the transparent electrode and the forward voltage Vf), good results are obtained when the annealing pressure is between 1 kPa and 30 kPa. That is, the nitride semiconductor light emitting element annealed under the reduced pressure of 1 kPa - 30 kPa can achieve the ohmic contact between the transparent electrode 105 and the p-side nitride semiconductor layer 104, can have lower sheet resistance of the transparent electrode 105 (in comparison with that annealed under the atmospheric pressure), and can have lower forward voltage Vf (in comparison with that annealed under the atmospheric pressure).

INDUSTRIAL APPLICABILITY

The nitride semiconductor light emitting element can be used as a semiconductor light emitting element for composing various light sources such as backlight light sources, displays, illuminations and vehicle lamps.

Brief Description of Reference Numerals

101:    Substrate
102:    N-side nitride semiconductor layer
103:    Light emitting layer
104:    P-side nitride semiconductor layer
105:    Transparent electrode
106:    P-side pad electrode

107:   N-side pad electrode
108:   Insulating layer

**Claims**

1. A method of manufacturing a nitride semiconductor light emitting element comprising an n-side nitride semiconductor layer (102), a p-side nitride semiconductor layer (104), and a transparent electrode (105) formed on the p-side nitride semiconductor layer (104), the method comprising:

   a semiconductor forming step of forming the n-side nitride semiconductor layer (102) and the p-side nitride semiconductor layer (104); and
   a transparent electrode forming step of forming the transparent electrode (105) on the p-side nitride semiconductor layer (104),
   **characterized in that** the transparent electrode forming step comprises a film forming sub-step of forming an indium oxide layer containing Ge and Si, and an annealing sub-step of annealing the nitride semiconductor light emitting element having the indium oxide layer,
   wherein the annealing in the annealing sub-step is carried out under a reduced pressure from 1 kPa to 30 kPa.

2. The method according to claim 1, wherein, in the film forming sub-step, the indium oxide layer is formed by sputtering a target comprising indium oxide containing Ge and Si.

3. The method according to claim 1 or 2, wherein the forming in the film forming sub-step is carried out under an inert gas atmosphere.

4. The method according to any one of claims 1 to 3, wherein, in the annealing sub-step, the annealing temperature is 500°C or more.

5. The method according to any one of claims 1 to 3, wherein, in the annealing sub-step, the annealing temperature is 525°C or more.

**Patentansprüche**

1. Verfahren zur Herstellung eines lichtemittierenden Nitridhalbleiterelements, umfassend eine n-seitige Nitridhalbleiterschicht (102), eine p-seitige Nitridhalbleiterschicht (104) und eine transparente Elektrode (105), die auf der p-seitigen Nitridhalbleiterschicht (104) gebildet ist, wobei das Verfahren umfasst:

   einen Halbleiterbildungsschritt des Bildens der n-seitigen Nitridhalbleiterschicht (102) und der p-seitigen Nitridhalbleiterschicht (104); und
   einen Transparente-Elektrode-Bildungsschritt des Bildens der transparenten Elektrode (105) auf der p-seitigen Nitridhalbleiterschicht (104),
   **dadurch gekennzeichnet, dass** der Transparente-Elektrode-Bildungsschritt einen Filmbildungsteilschritt des Bildens einer Indiumoxidschicht, die Ge und Si enthält, umfasst, sowie einen Annealingteilschritt des Annealens des lichtemittierenden Nitridhalbleiterelements, das die Indiumoxidschicht hat,
   wobei das Annealen in dem Annealingteilschritt unter einem reduzierten Druck von 1 kPa bis 30 kPa durchgeführt wird.

2. Verfahren nach Anspruch 1, wobei in dem Filmbildungsteilschritt die Indiumoxidschicht durch Sputtern eines Targets gebildet wird, das Indiumoxid, welches Ge und Si enthält, umfasst.

3. Verfahren nach Anspruch 1 oder 2, wobei das Bilden in dem Filmbildungsteilschritt unter einer Inertgasatmosphäre durchgefürt wird.

4. Verfahren nach einem der Ansprüche 1 bis 3, wobei in dem Annealingteilschritt die Annealingtemperatur 500°C oder mehr beträgt.

5. Verfahren nach einem der Ansprüche 1 bis 3, wobei in dem Annealingteilschritt die Annealingtemperatur 525°C oder mehr beträgt.

**Revendications**

1. Procédé de fabrication d'un élément émetteur de lumière à semi-conducteur nitruré comprenant une couche de semi-conducteur nitruré côté n (102), une couche de semi-conducteur nitruré côté p (104), et une électrode transparente (105) formée sur la couche de semi-conducteur nitruré côté p (104), le procédé comprenant :

   une étape de formation de semi-conducteur consistant à former la couche de semi-conducteur nitruré côté n (102) et la couche de semi-conducteur nitruré côté p (104) ; et
   une étape de formation d'électrode transparente consistant à former l'électrode transparente (105) sur la couche de semi-conducteur nitruré côté p (104),
   **caractérisé en ce que** l'étape de formation d'électrode transparente comprend une sous-étape de formation de film consistant à former une couche d'oxyde d'indium contenant du Ge et du Si, et une sous-étape de recuit consistant à recuire l'élément émetteur de lumière à semi-conducteur nitruré comportant la couche d'oxyde d'indium,
   dans lequel le recuit à la sous-étape de recuit est réalisé sous une pression réduite de 1 kPa à 30 kPa.

2. Procédé selon la revendication 1, dans lequel, à la sous-étape de formation de film, la couche d'oxyde d'indium est formée par pulvérisation d'une cible comprenant de l'oxyde d'indium contenant du Ge et du Si.

3. Procédé selon la revendication 1 ou 2, dans lequel la formation à la sous-étape de formation de film est réalisée sous une atmosphère de gaz inerte.

4. Procédé selon l'une quelconque des revendications 1 à 3, dans lequel, à la sous-étape de recuit, la température de recuit est supérieure ou égale à 500 °C.

5. Procédé selon l'une quelconque des revendications 1 à 3, dans lequel, à la sous-étape de recuit, la température de recuit est supérieure ou égale à 525 °C.

[Fig. 1]

[Fig. 2]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001210867 A
- JP 2003060236 A
- JP 2007305975 A